# EUROPEAN PATENT APPLICATION

(11) **EP 4 513 738 A1**
(43) Date of publication of application: **26.02.2025**
(21) Application number: 23811555.4
(22) Date of filing: 27.04.2023
(51) Int. Cl.: H02M 7/48

(54) **POWER CONVERSION DEVICE, SWITCH FAULT DETECTION METHOD FOR POWER CONVERSION DEVICE, AND PROGRAM**

(30) Priority: 24.05.2022 JP 2022084609
(71) Applicant: MITSUBISHI HEAVY INDUSTRIES THERMAL SYSTEMS, LTD., Tokyo 100-8332 (JP)
(72) Inventor: SATO, Hidetaka, Tokyo 100-8332 (JP); ITO, Fukuaki, Tokyo 100-8332 (JP); KOJIMA, Ryota, Tokyo 100-8332 (JP); MIYABE, Kimihiro, Nagoya-shi, Aichi 460-0008 (JP); KUWATA, Rui, Tokyo 100-8332 (JP); BOKU, Kairyu, Tokyo 100-8332 (JP)
(74) Representative: Cabinet Beau de Loménie
(86) International application number: PCT/JP2023/016571
(87) International publication number: WO 2023/228677

(57) **Abstract**

To detect a short-circuit failure and an open-circuit failure of a switch used in a rush current suppression circuit without using a voltage detector, a power converter (1) includes a smoothing capacitor (21) connected to DC bus lines of a DC power supply unit (2), a resistor (22) for suppressing rush current flowing into the smoothing capacitor (21), and a switch (23) connected parallel to the resistor (22). The power converter (1) includes: a current sensor (26) connected in series to the switch (23) and configured to measure current flowing in the switch (23); a switch control unit configured to open the switch (23) at start of operation and then close the switch (23) when a predetermined condition is met; and a failure detecting unit configured to detect a failure of the switch based on a measured value of the current sensor (26).

## Description

### [Technical Field]

The present disclosure relates to a power converter, a method of detecting a switch failure of a power converter, and a program.

### [Background Art]

In power converters, a smoothing capacitor is conventionally provided to smooth variable components of DC power. In such a power converter having a smoothing capacitor, when the power converter is powered on, much higher current than in the steady state occurs in a short time to charge the smoothing capacitor (hereafter, referred to as "rush current").

To suppress such rush current, a rush current suppression circuit is provided in the power converter. For example, the rush current suppression circuit has a configuration including a resistor provided on the input side of the smoothing capacitor and a switch connected parallel to the resistor. During startup of the power converter, the switch is opened to charge the smoothing capacitor via the resistor, and after completion of the charging, the switch is closed to start normal operation (see Patent Literatures 1 and 2).

Herein, when the switch used in the rush current suppression circuit fails, it is required to immediately detect such a failure in order to prevent deterioration, damage, or the like of elements in the power converter.

For example, Patent Literature 1 discloses that the resistor voltage between both ends of the resistor or the resistor current flowing in the resistor of the rush current suppression circuit is measured to determine that the switch has failed when the resistor voltage or the resistor current does not decrease below a second threshold even after a predetermined time defined in advance has elapsed after the switch was closed.

Further, Patent Literature 2 discloses a method that employs a self-extinguishing device such as a gate turn-off (GTO) thyristor as the switch and provides voltage detectors for measuring the voltage on the input side and the voltage on the output side of the rush current suppression circuit, respectively, and detects a short-circuit failure of the switch based on the voltages measured by the voltage sensor and on the gate control signal to the switch. Specifically, Patent Literature 2 discloses that the power converter is stopped after the switch is turned off during stopping operation of the power converter, thereby a period in which the switch is off is provided, and in this period, a short-circuit failure of the switch is detected if no voltage difference occurs between the input side voltage and the output side voltage measured by the voltage detectors.

### [Citation List]

### [Patent Literature]

[PTL 1]
   Japanese Patent Application Laid-Open No. 2020-145809
[PTL 2]
   Japanese Patent Application Laid-Open No. 2001-245401

### [Summary of Invention]

### [Technical Problem]

In the method of determining a failure of a switch disclosed in Patent Literature 1, although it is possible to easily detect an open-circuit failure of the switch, it is difficult to determine an incomplete-disconnection failure of the switch.

In the method of determining a failure of a switch disclosed in Patent Literature 2, although it is possible to quickly detect a short-circuit failure of the switch, it is necessary to provide voltage detectors on the input side and the output side of the rush current suppression circuit.

The present disclosure has been made in view of such circumstances and intends to provide a power converter, a method of detecting a switch failure of a power converter, and a program that enable detection of a short-circuit failure and an open-circuit failure of a switch used in a rush current suppression circuit without using a voltage detector.

### [Solution to Problem]

The first aspect of the present disclosure is a power converter including a smoothing capacitor connected to DC bus lines of a DC power supply unit, a resistor for suppressing rush current flowing into the smoothing capacitor, and a switch connected parallel to the resistor, and the power converter includes: a current sensor connected in series to the switch and configured to measure current flowing in the switch; a switch control unit configured to open the switch at start of operation and then close the switch when a predetermined condition is met; and a failure detecting unit configured to detect a failure of the switch based on a measured value of the current sensor.

The second aspect of the present disclosure is a program that causes a computer to function as the failure detecting unit described above.

The third aspect of the present disclosure is a method of detecting a switch failure of a power converter including a smoothing capacitor connected to DC bus lines of a DC power supply unit, a resistor for suppressing rush current flowing into the smoothing capacitor, and a switch connected parallel to the resistor, and the method includes: measuring current flowing in the switch by a current sensor connected in series to the switch; at a computer, controlling opening and closing of the switch so as to open the switch at start of operation and then close the switch when a predetermined condition is met; and detecting a failure of the switch based on opening and closing control of the switch and a measured value of the current sensor.

### [Advantageous Effects of Invention]

The present disclosure achieves an advantageous effect that it is possible to detect a short-circuit failure and an open-circuit failure of a switch used in a rush current suppression circuit without using a voltage detector.

### [Brief Description of Drawings]

[Fig. 1]

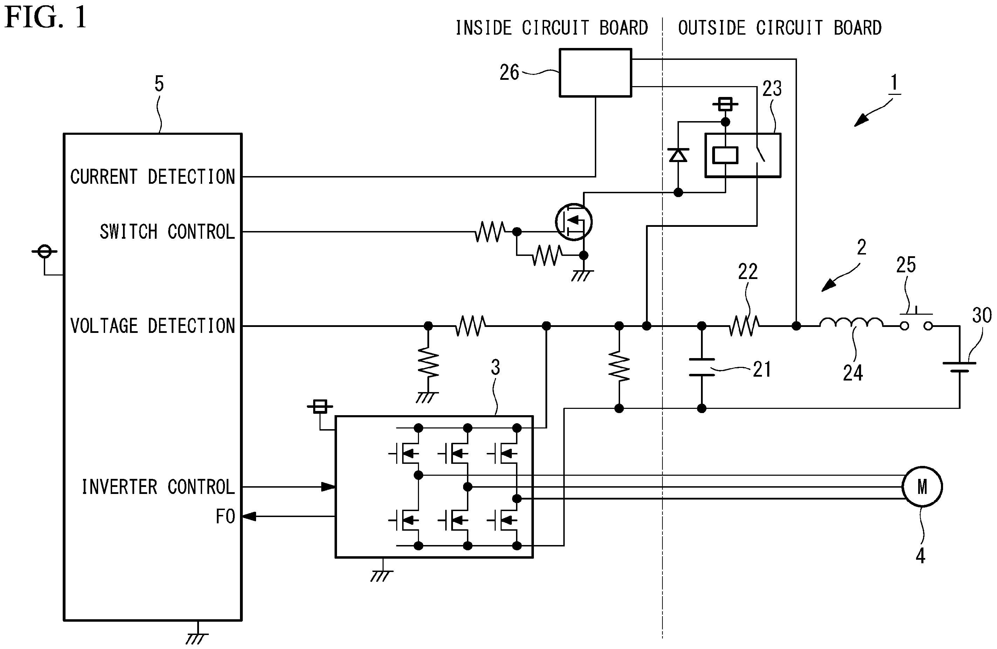

   Fig. 1 is a circuit diagram illustrating a general configuration of a power converter according to a first embodiment of the present disclosure.
[Fig. 2]

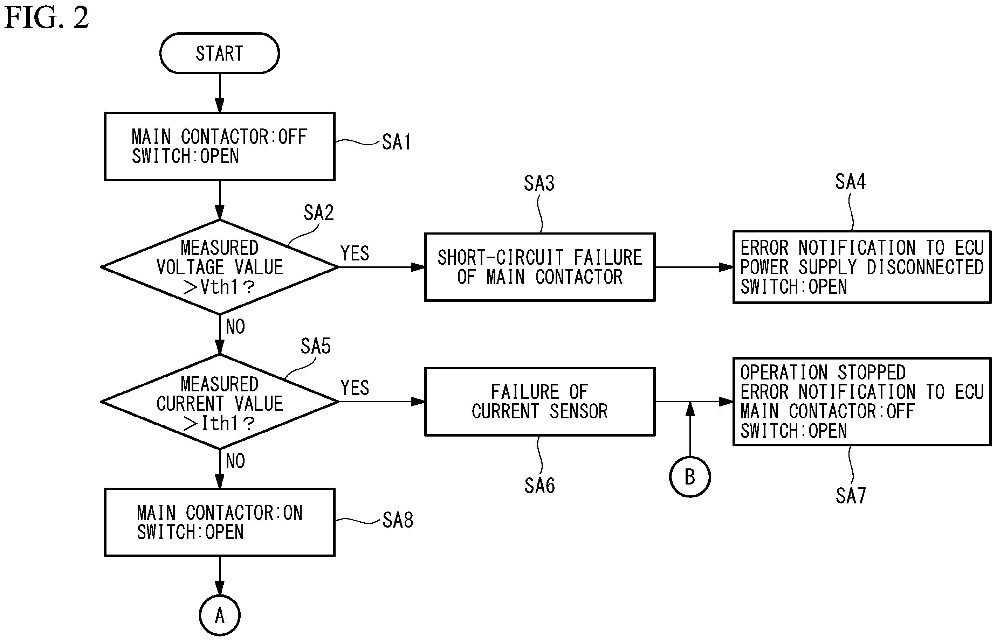

   Fig. 2 is a flowchart illustrating an example of control during startup of the power converter performed by a control device according to the first embodiment of the present disclosure.
[Fig. 3]

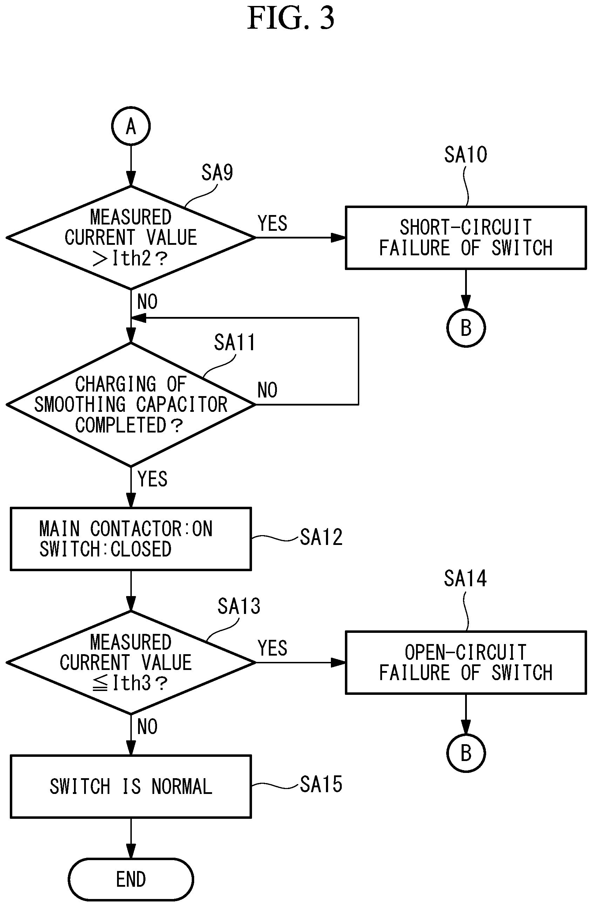

   Fig. 3 is a flowchart illustrating an example of control during startup of the power converter performed by the control device according to the first embodiment of the present disclosure.
[Fig. 4]

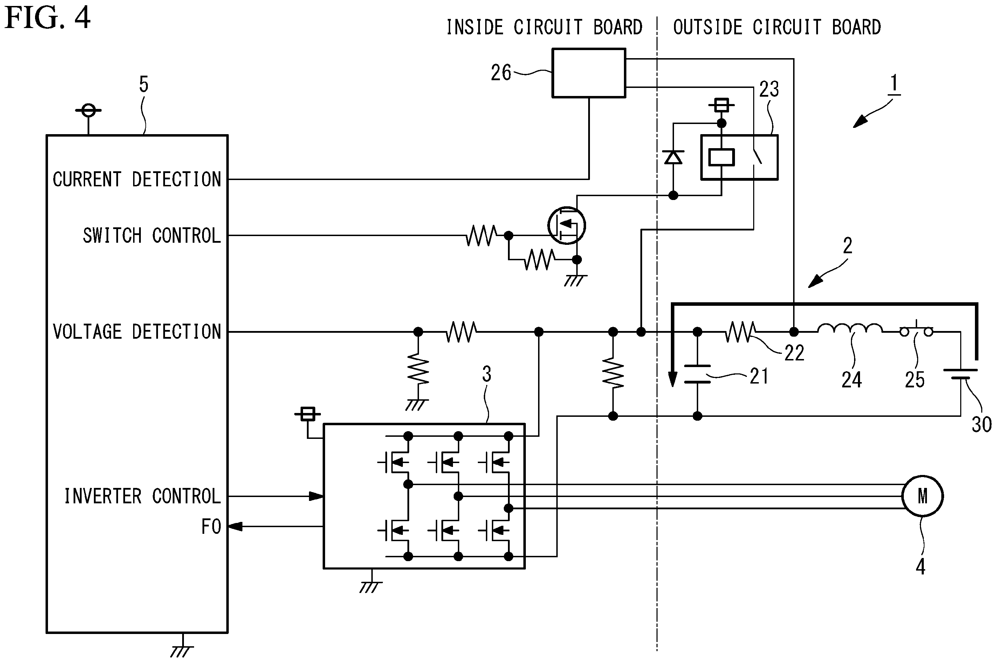

   Fig. 4 is a diagram illustrating a route on which current flows when a main contactor is turned on with a switch left opened assuming that the power converter according to the first embodiment of the present disclosure is normal.
[Fig. 5]

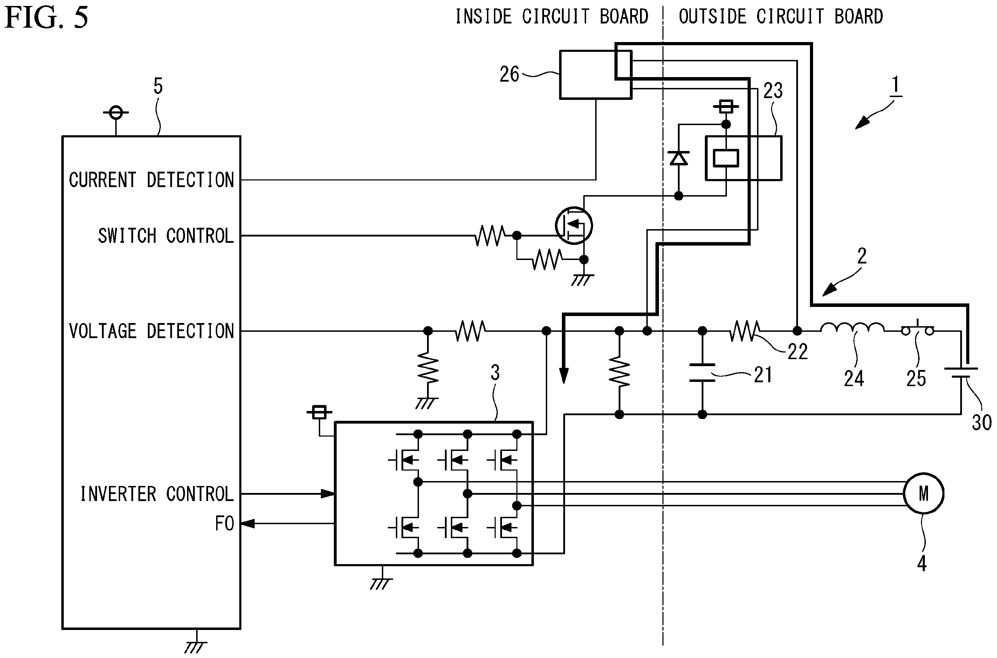

   Fig. 5 is a diagram illustrating a route on which current flows when the switch is closed with the main contactor left turned on assuming that the power converter according to the first embodiment of the present disclosure is normal.
[Fig. 6]

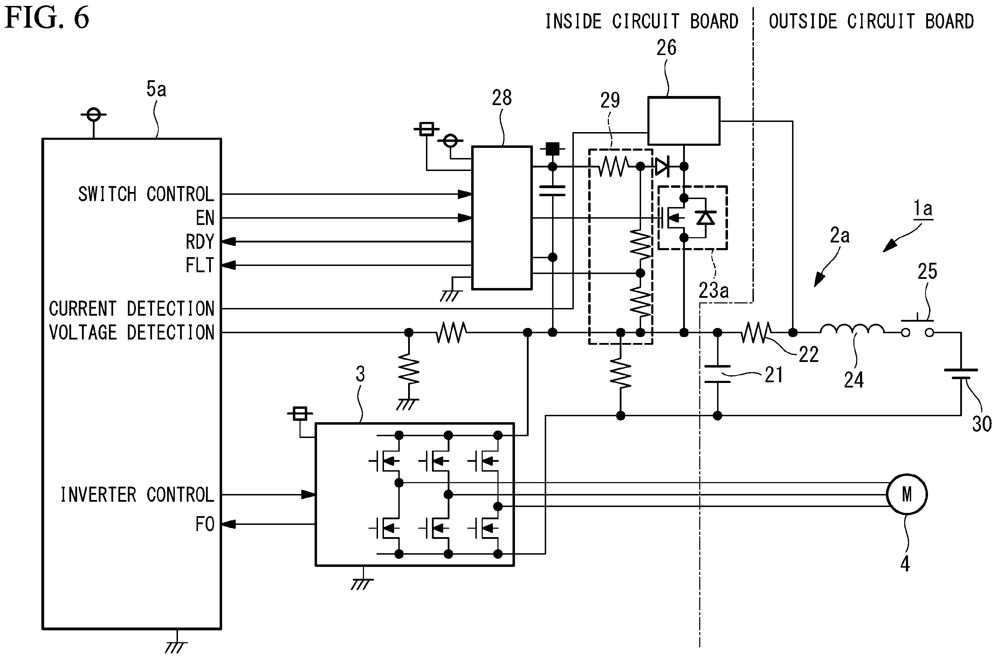

   Fig. 6 is a circuit diagram illustrating a general configuration of a power converter according to a second embodiment of the present disclosure.
[Fig. 7]

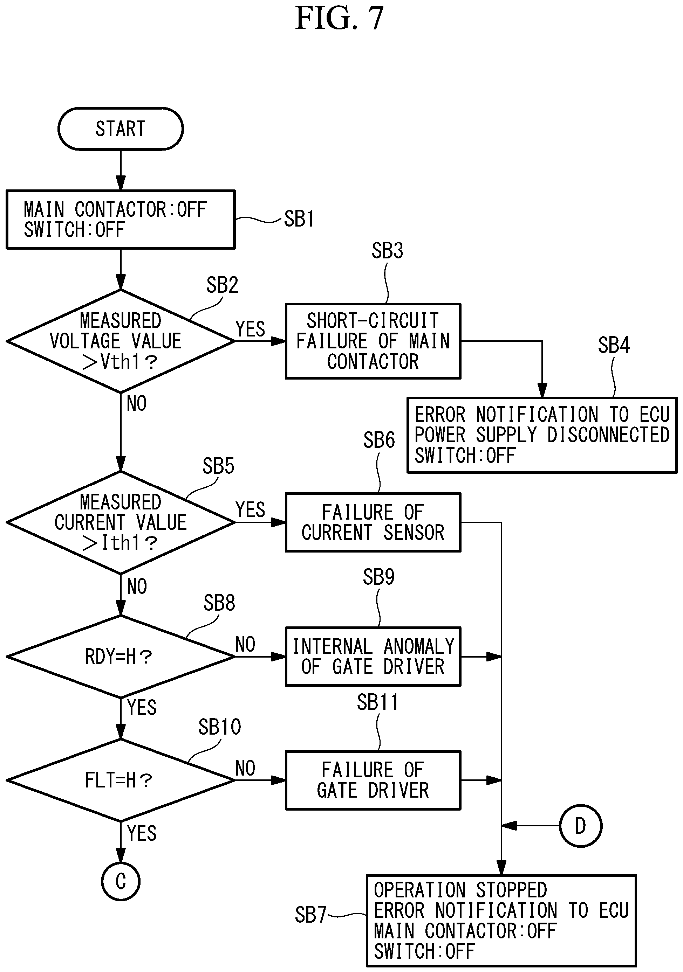

   Fig. 7 is a flowchart illustrating an example of control during startup of the power converter performed by a control device according to the second embodiment of the present disclosure.
[Fig. 8]

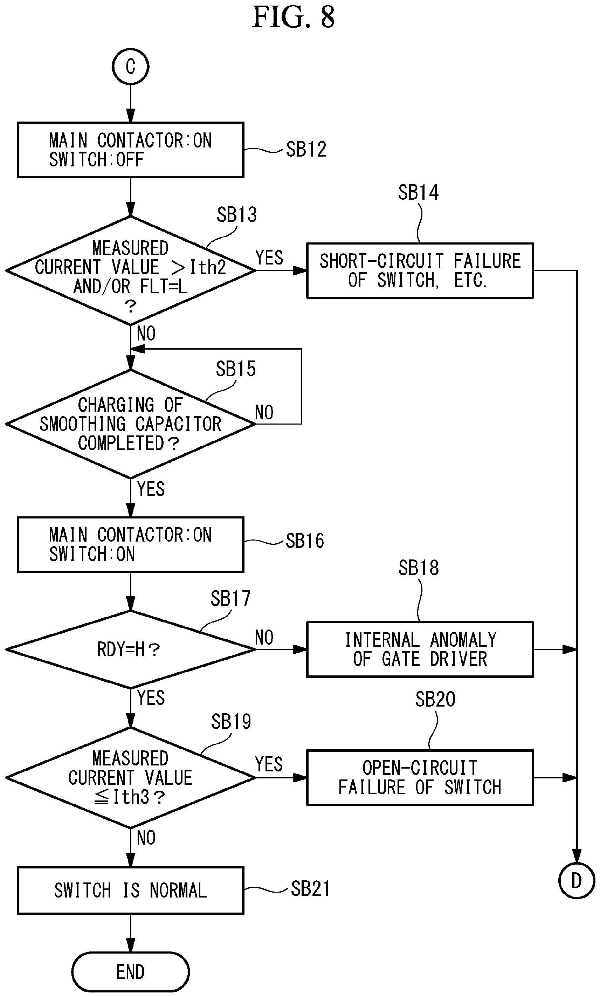

   Fig. 8 is a flowchart illustrating an example of control during startup of the power converter performed by the control device according to the second embodiment of the present disclosure.

### [Description of Embodiments]

### [First Embodiment]

A power converter, a method of detecting a switch failure of a power converter, and a program according to a first embodiment of the present disclosure will be described below with reference to the drawings.

For example, the power converter according to the present embodiment is used for motor drive for driving an electric compressor. An example of use of such an electric compressor may be a refrigerating unit for land transportation.

In the following, description will be provided with an example of a case where the power converter according to the present embodiment is applied to a motor drive device used for driving an electric compressor mounted on a refrigerating unit for land transportation.

Note that the power converter of the present disclosure can be applied to various devices that require power conversion without being limited to the use illustrated below.

Fig. 1 is a circuit diagram illustrating a general configuration of a power converter 1 according to the first embodiment of the present disclosure. As illustrated in Fig. 1, the power converter 1 includes a DC power supply unit 2 and an inverter 3 that converts DC power from the DC power supply unit 2 into AC power. For example, the AC power from the inverter 3 is applied to a motor 4 and drives the motor 4. Furthermore, the power converter 1 includes a control device 5 that controls respective elements of the power converter 1.

The DC power supply unit 2 is provided with a smoothing capacitor 21 used for smoothing variable components of DC power. One end of the smoothing capacitor 21 is connected to the positive terminal circuit of the DC power supply unit 2, and the other end of the smoothing capacitor 21 is connected to the negative terminal circuit of the DC power supply unit 2. Further, the DC power supply unit 2 is provided with a rush current suppression circuit used for suppressing rush current flowing into the smoothing capacitor 21 when powered on. The rush current suppression circuit has, for example, a resistor 22 provided on the power supply side from the smoothing capacitor 21 and a switch 23 connected parallel to the resistor 22. For example, the resistor 22 is connected to the positive terminal circuit of the DC power supply unit 2. For example, the switch 23 is a mechanical switch such as a relay switch.

The DC power supply unit 2 has a coil 24 and a main contactor 25 connected in series to the resistor 22. For example, turning on and off (opening and closing) of the main contactor 25 is controlled by an on-vehicle control device (for example, a vehicle-side Electronic Control Unit (ECU)). A filter circuit is formed of the coil 24 and the smoothing capacitor 21. The filter circuit suppresses noise or harmonic current flowing to the output side.

A current sensor 26 is connected in series to the switch 23. The current sensor 26 measures the current flowing in the switch 23 and outputs the measured current value to the control device 5. For example, the current sensor 26 is an isolated current sensor. An example of the isolated current sensor may be, a Hall element, an insulating amplifier, or the like.

Switching of a bridge circuit of the inverter 3, opening and closing of the switch 23, and the like are controlled by the control device 5.

For example, the control device 5 is connected to the upstream ECU via communication lines and transmits and receives control signals to and from the upstream ECU. The control device 5 drives the inverter 3 based on a control signal from the upstream ECU and thereby controls the AC power to be applied to the motor 4. The control device 5 controls opening and closing of the switch 23 based on a control signal from the upstream ECU and the voltage between both ends of the smoothing capacitor 21.

Herein, "upstream ECU" may be an ECU mounted on a main circuit board installed inside the refrigerating unit for land transportation, may be a vehicle-side ECU, or may include both of these ECUs.

A measured voltage value in accordance with the positive voltage of the DC power supply unit 2 is output to the control device 5. For example, the measured voltage value is a measured voltage value divided at a predetermined resistance ratio from the voltage between both ends of the smoothing capacitor 21. Further, a measured current value measured by the current sensor 26 is output to the control device 5.

The control device 5 has a failure detecting function (failure detecting unit) of detecting a failure of the main contactor 25 and the switch 23 by using the measured voltage value and the measured current value described above.

For example, the control device 5 is a microcomputer. For example, the control device 5 includes a central processing unit (CPU), a main storage device (main memory) formed of a writable memory such as a cache memory, a random access memory (RAM), or the like, a secondary storage device (secondary storage: memory), and the like. The secondary storage device is a non-transitory computer readable storage medium. An example of the non-transitory computer readable storage medium may be a magnetic disk, a magneto-optical disk, a CD-ROM, a DVD-ROM, a semiconductor memory, or the like.

Next, control during startup of the power converter 1 performed by the control device 5 will be described with reference to Fig. 2 and Fig. 3. Fig. 2 and Fig. 3 are flowchart diagrams illustrating an example of a processing procedure during startup of the power converter 1. A series of processes described later are stored in the secondary storage device of the control device 5 in a form of a program as an example, and various functions are implemented when the CPU (processor) loads the program into the main storage device and performs modification and calculation processes on information.

First, in the power converter 1 before powered on, the main contactor 25 has been turned off (in an open state) and the switch 23 is in an open state (SA1). In this state, the control device 5 determines whether or not the measured voltage value is greater than a first voltage threshold Vth1 (SA2). As a result, if the measured voltage value is greater than the first voltage threshold Vth1 (SA2: YES), it is determined that the main contactor 25 has a short-circuit failure (SA3), and error notification including the detail of the failure is provided to the ECU (SA4). Accordingly, power supply to the power converter 1 is disconnected by a contactor or the like different from the main contactor 25. Further, the switch 23 is left the open state (an off state).

In contrast, if the measured voltage value is less than or equal to the first voltage threshold Vth1 in step SA2 (SA2: NO), it is determined whether or not the measured current value is greater than a predetermined first current threshold (first threshold) Ith1 (SA5). As a result, if the measured current value is greater than the first current threshold Ith1 (SA5: YES), this indicates that current is erroneously detected despite the fact that no current is flowing. Thus, it is determined that the current sensor 26 has failed (SA6), and error notification including the detail of the failure is provided to the ECU (SA7). At this time, the main contactor 25 is opened, and the switch 23 is left opened.

If the measured current value is less than or equal to the predetermined first current threshold Ith1 in step SA5 (SA5: NO), the control device 5 turns on the main contactor 25 while leaving the switch 23 in the open state (SA8). Accordingly, when the state is normal, as illustrated in Fig. 4, DC power from the power supply (for example, an on-vehicle high-voltage battery) 30 is supplied to the power converter 1. Accordingly, current flows from the power supply 30 to the smoothing capacitor 21 via the main contactor 25, the coil 24, and the resistor 22. At this time, rush current is suppressed by the resistor 22.

Subsequently, the control device 5 determines whether or not the measured current value is greater than a second current threshold Ith2 (SA9 of Fig. 3). As a result, if the measured current value is greater than the second current threshold Ith2 (SA9: YES), a short-circuit failure of the switch 23 is detected (SA10), and the process proceeds to step SA7 of Fig. 2.

In contrast, if the measured current value is less than or equal to the second current threshold Ith2 (SA9: NO), it is determined whether or not charging of the smoothing capacitor 21 is completed (SA11). For example, this may be determined in accordance with whether or not the measured voltage value is a preset charge threshold or higher. Further, this may be determined in accordance with the time elapsed from the time of turning on of the main contactor 25. Since this feature is of a known technique, any known technique can be suitably employed.

Subsequently, if it is determined that the charging of the smoothing capacitor 21 is completed (SA11: YES), the control device 5 closes the switch 23 while maintaining the main contactor 25 in the on state (SA12). Accordingly, when the state is normal, as illustrated in Fig. 5, current will flow from the power supply 30 to the inverter 3 via the main contactor 25, the coil 24, the current sensor 26, and the switch 23.

Subsequently, the control device 5 determines whether or not the measured current value is less than or equal to a third current threshold Ith3 (SA13). As a result, if the measured current value is less than or equal to the third current threshold Ith3 (SA13: YES), an open-circuit failure of the switch 23 is detected (SA14), and the process returns to step SA7 of Fig. 2.

In contrast, if the measured current value is greater than the third current threshold Ith3 (SA13: NO), the control device 5 determines that the switch 23 is normal (SA15) and ends the process during startup. The control device 5 then performs typical operation control, that is, inverter control or the like and thereby continues to perform the motor drive control based on a control signal from the on-vehicle ECU.

As described above, according to the power converter 1, the method of detecting a switch failure, and the program of the present embodiment, the following effects and advantages are achieved.

The power converter 1 includes the current sensor 26 connected in series to the switch 23 and configured to measure the current flowing in the switch 23 and the control device (failure detecting unit) 5 configured to detect a failure of the switch 23 based on the measured value of the current sensor 26. The current sensor 26 is connected in series to the switch 23 and thus can directly measure the current flowing in the switch 23. This enables quick detection of both an open-circuit failure and a short-circuit failure of the switch 23. Further, failure detection of the switch 23 can be performed without using a voltage sensor.

### [Second Embodiment]

A power converter 1a, a method of detecting a switch failure of the power converter 1a, and a program according to a second embodiment of the present disclosure will be described with reference to the drawings. The power converter 1a according to the present embodiment differs from the first embodiment described above in that a semiconductor switch is used as a switch 23a. In the following, features common to the first embodiment will be labeled with the same references, the description thereof will be omitted, and different features will be mainly described.

Fig. 6 is a circuit diagram illustrating the general configuration of the power converter 1a according to the second embodiment of the present disclosure. As illustrated in Fig. 6, a DC power supply unit 2a of the power converter 1a according to the present embodiment has the switch 23a. The switch 23a is a semiconductor switch and may be a SiC-MOSFET, an insulated gate bipolar transistor (IGBT), or the like as an example.

Furthermore, the power converter 1a has a gate driver (switch drive unit) 28 for driving the switch 23a. For example, the gate driver 28 is an isolated gate driver. The gate driver 28 controls turning on and off of the switch 23a based on switch control signals from a control device 5a (for example, a microcomputer). Herein, the on-state of the switch 23a means that current flows with the switch 23a left closed, and the off-state of the switch 23a means that no current flows with the switch 23a left opened.

The gate driver 28 has an internal anomaly diagnosis function. For example, the gate driver 28 determines that the input/output is abnormal if the output voltage relative to the input voltage is a value other than a predetermined voltage value (input/output logic mismatch), then sets an RDY signal to "L" (Low), and outputs this RDY signal. Note that, when no internal anomaly is detected, that is, in a normal state, the RDY signal is set to "H" (High).

Further, the gate driver 28 has a function of detecting that the switch 23a is in an overcurrent state and, in response to detecting occurrence of an overcurrent state, sets an FLT signal to "L" (Low). For example, when overcurrent flows in the switch 23a, a voltage (potential difference) that is greater than or equal to a predetermined value occurs between the drain and the source of the switch 23a (SiC-MOSFET). This predetermined value is set in accordance with the electric characteristic of the switch 23a and a voltage dividing resistor 29. When a drain-source voltage that is greater than or equal to the predetermined value occurs, the voltage output from the voltage dividing resistor 29 to the gate driver 28 will be changed to a value that is greater than or equal to a predetermined threshold. In response to detecting that this voltage is greater than or equal to the threshold, the gate driver 28 detects overcurrent in the switch 23a, sets the FLT signal to "L", and outputs this FLT signal. When no overcurrent in the switch 23a is detected, that is, in a normal state, the FLT signal is set to "H" (Hight).

A control method during startup of the power converter 1 performed by the control device 5a according to the present embodiment will be described with reference to Fig. 7 and Fig. 8. Fig. 7 and Fig. 8 are flowchart diagrams illustrating an example of a processing procedure during startup of the power converter 1. A series of processes described later are stored in the secondary storage device of the control device 5a in a form of a program as an example, and various functions are implemented when the CPU (processor) loads the program into the main storage device and performs modification and calculation processes on information.

Since steps SB1 to SB7 correspond to steps SA1 to SA7 according to the first embodiment described above, respectively, the description thereof will be omitted here.

In step SB8, the control device 5a determines whether or not the RDY signal from the gate driver 28 is "H", that is, indicates a normal state (SB8). As a result, if the RDY signal is "L" (SB8: NO), it is determined that there is an internal anomaly of the gate driver (SB9), and the process proceeds to step SB7. In contrast, if the RDY signal is "H" (SB8: YES), it is then determined whether or not the FLT signal is "H", that is, indicates the normal state (SB10).

As a result, if the FLT signal is "L" (SB10: NO), this means that the gate driver 28 determines that overcurrent is flowing in the switch 23a despite the fact that the main contactor 25 is not turned on and no voltage is applied. Thus, it is determined that the gate driver 28 has failed (SB11), and the process proceeds to step SB7. In contrast, if the FLT signal is "H" (SB10: YES), the main contactor 25 is turned on with the switch 23a left in the open state (SB12 of Fig. 8). Accordingly, when the state is normal, DC power from the power supply (for example, an on-vehicle high-voltage battery) 30 is supplied to the power converter 1 (see Fig. 4).

In subsequent step SB13, the control device 5a determines whether or not the measured current value is greater than the second current threshold Ith2 and determines whether or not the FLT signal is "L" (SB13). As a result, if both the conditions are met, the control device 5a determines that the switch has a short-circuit failure (SB14), and the process proceeds to step SB7 (see Fig. 7). Accordingly, the main contactor 25 is turned off, and the switch 23a is maintained in the off state.

When a short-circuit failure has actually occurred in the switch 23a, the measured current value will be greater than the second current threshold Ith2, and also the FLT signal will be "L". That is, both the two conditions of step SB13 will be met. Therefore, by taking a logical AND of the two conditions, it is possible to improve the detection accuracy of a short-circuit failure of the switch 23a.

In contrast, if only one of the two conditions described above is met, this means that there is inconsistency between the detection results of the current sensor 26 and the gate driver 28. In such a case, it is not possible to determine whether or not a short-circuit failure has occurred in the switch 23a, and it is possible to determine that a failure has occurred in the current sensor 26 or the gate driver 28. Therefore, if a logical AND of both the conditions is not met in step SB13, it is determined that at least any one of a short-circuit failure of the switch 23a, a failure of the current sensor 26, and a failure of the gate driver 28 has occurred.

In contrast, if none of the conditions is met in step SB13 (SB13: NO), it is determined whether or not the charging of the smoothing capacitor 21 is completed (SB15). This determination condition is the same as that of SA11 of the first embodiment.

If it is determined that charging of the smoothing capacitor 21 is completed (SB15: YES), the control device 5a turns on the switch 23a while the main contactor 25 is maintained in the on state (SB16). Specifically, the control device 5a outputs a switch control signal to the gate driver 28 that turns on the switch 23a. The gate driver 28 applies a gate voltage to the gate of the switch 23a, and thereby the switch 23a is turned on. When the state is normal, current will flow from the power supply 30 via the main contactor 25, the coil 24, the current sensor 26, and the switch 23a (see Fig. 5).

The control device 5a determines whether or not the RDY signal from the gate driver 28 is "H", that is, indicates the normal state (SB17). If the RDY signal is "L" (SB17: NO), it is determined that there is an internal anomaly of the gate driver (SB18), and the process proceeds to step SB7 of Fig. 7. In contrast, if the RDY signal is "H" (SB17: YES), it is then determined whether or not the measured current value is less than or equal to the third current threshold Ith3 (SB19). If the measured current value is less than or equal to the third current threshold Ith3 (SB19: YES), it is detected that the switch 23a has an open-circuit failure (SB20), and the process proceeds to step SB7 of Fig. 7.

In contrast, if the measured current value is greater than the third current threshold Ith3 (SB19: NO), the control device 5a determines that the switch 23a is normal (SB21) and ends the process during startup. The control device 5a then performs typical operation control, that is, inverter control or the like and thereby continues to perform the motor drive control based on a control signal from the on-vehicle ECU.

As described above, according to the power converter 1a, the method of detecting a switch failure, and the program of the present embodiment, the following effects and advantages are achieved.

In the power converter 1a, the switch 23a is a semiconductor switch, and the gate driver 28 for driving the semiconductor switch is provided. The gate driver 28 has a function of determining whether or not overcurrent is flowing in the switch 23a (the overcurrent detecting unit for the switch 23a) and an anomaly diagnosis function of diagnosing an anomaly of the gate driver 28 itself (the anomaly diagnosis unit). Therefore, the control device 5a can perform failure determination on the switch 23a, failure determination on the current sensor 26, and failure determination on the gate driver 28 based on the FLT signal used for notifying that overcurrent is detected and the RDY signal used for notifying that the gate driver 28 is abnormal.

Although the present disclosure has been described above with reference to the embodiments, the technical scope of the present disclosure is not limited to the scope described in the above embodiments. Various modifications or alterations can be applied to the above embodiments within the scope not departing from the spirit of the disclosure, and forms to which such modifications or alterations are applied also fall in the technical scope of the present disclosure. Further, the above embodiments may be combined as appropriate.

Further, the process flow during startup described in the above embodiments is an example, and an unnecessary step may be deleted, a new step may be added, or the process order may be exchanged within the scope not departing from the spirit of the present disclosure.

For example, although the case where DC power is supplied from the power supply 30 has been described as an example in the above embodiments, the disclosure is not limited to this example. For example, the power supply 30 may be an AC power supply. In such a case, for example, as disclosed in Patent Literature 1, the power converters 1, 1a may further include a rectifier for converting AC power into DC power.

Further, for the first current threshold Ith1, the second current threshold Ith2, and the third current threshold Ith3 in each embodiment described above, all of these thresholds may be set to the same value, some of these thresholds may be set to the same value, or all of these thresholds may be set to different values. How to determine these thresholds is a design matter.

Further, although the case where a current value is output from the current sensor 26 has been described as an example in each embodiment described above, the disclosure is not limited thereto. For example, the current sensor 26 has current-to-voltage conversion characteristics to convert a current value into a voltage value, a current value may be converted into a voltage value based on this conversion characteristic, and the voltage value may be output to the control devices 5, 5a. In such a case, also for the first current threshold Ith1, the second current threshold Ith2, and the third current threshold Ith3, a voltage obtained after current-to-voltage conversion is performed using common current-to-voltage conversion characteristics can be used.

The power converter 1, the method of detecting a switch failure of the power converter, and the program according to the embodiments described above may be understood as follows, for example.

The power converter (1, 1a) according to the first aspect of the present disclosure is a power converter including a smoothing capacitor (21) connected to DC bus lines of a DC power supply unit (2, 2a), a resistor (22) for suppressing rush current flowing into the smoothing capacitor, and a switch (23, 23a) connected parallel to the resistor, and the power converter includes: a current sensor (26) connected in series to the switch and configured to measure current flowing in the switch; a switch control unit (5, 5a) configured to open the switch at start of operation and then close the switch when a predetermined condition is met; and a failure detecting unit (5, 5a) configured to detect a failure of the switch based on a measured value of the current sensor.

According to the power converter of the present disclosure, since the current sensor is connected in series to the switch, the current flowing in the switch can be directly measured. This enables quick detection of both an open-circuit failure and a short-circuit failure of the switch. Further, failure detection on the switch can be performed without using a voltage sensor.

In the power converter according to the second aspect of the present disclosure, in the first aspect, the switch (23a) may be a semiconductor switch, and the power converter may include a switch drive unit (28) configured to drive the semiconductor switch based on an instruction from the switch control unit.

The use of a semiconductor switch can improve a reaction speed compared to a case where a mechanical switch is used. Further, mechanical switches with excellent current-resistance characteristics tend to be large and expensive. Compared to such mechanical switches, the use of a semiconductor switch can reduce the size and the cost of the element.

In the power converter according to the third aspect of the present disclosure, in the first aspect or the second aspect, the current sensor is, for example, an isolated current sensor.

Since an isolated current sensor is employed, the current-resistance characteristics can be improved. In particular, in a case of power converters used for on-vehicle air conditioners or the like, since power is supplied from an on-vehicle high-voltage battery, a high-voltage power supply is used. Even in such a case, the use of the isolated current sensor enables reliable measurement of the current flowing in the switch.

In the power converter according to the fourth aspect of the present disclosure, in any one of the first aspect to the third aspect, in a state where no voltage is being applied to the DC power supply unit, the failure detecting unit may detect a failure of the current sensor when the measured value of the current sensor is greater than a predetermined first threshold.

The state where no voltage is being applied to the DC power supply unit means a state where no current is flowing in the switch. In such a case, if the measured value of the current sensor is greater than the first threshold, this is determined as a failure of the current sensor itself.

In the power converter according to the fifth aspect of the present disclosure, in any one of the first aspect to the fourth aspect, when a voltage is being applied to the DC power supply unit and the switch is controlled in an open state by the switch control unit, the failure detecting unit may detect a short-circuit failure of the switch when the measured value of the current sensor is greater than a predetermined second threshold.

When a voltage is being applied to the DC power supply unit and the switch is controlled in an open state, this means a state where no current is flowing in the switch. In such a case, if the measured value greater than the second threshold is detected by the current sensor, it is determined that the switch has a short-circuit failure.

In the power converter according to the sixth aspect of the present disclosure, in any one of the first aspect to the fourth aspect, when a voltage is being applied to the DC power supply unit and the switch is controlled in a closed state by the switch control unit, the failure detecting unit may detect an open-circuit failure of the switch when the measured value of the current sensor is less than or equal to a predetermined third threshold.

When a voltage is applied to the DC power supply unit and the switch is controlled in a closed state, this means a state where current is flowing in the switch. In such a case, if the measured value less than or equal to the third threshold is detected by the current sensor, it is determined that the switch has an open-circuit failure.

In the power converter according to the seventh aspect of the present disclosure, in the second aspect, the switch drive unit may include an anomaly diagnosis unit, and the failure detecting unit may detect an anomaly of the switch drive unit based on an anomaly notification signal (RDY signal "L") output from the switch drive unit.

Since the switch drive unit includes the anomaly diagnosis unit, an anomaly of the switch drive unit can be easily detected.

In the power converter according to the eighth aspect of the present disclosure, in the second aspect or the seventh aspect, the switch drive unit may include an overcurrent detecting unit configured to detect whether or not overcurrent is flowing in the switch (23a), and the failure detecting unit may detect a failure of the switch by evaluating consistency between an overcurrent notification signal (FLT signal "L") output from the switch drive unit and failure detection based on the measured value of the current sensor.

When a short-circuit failure has occurred in the switch, the measured value of the current sensor is greater than the second threshold, and in addition, the overcurrent notification signal from the switch drive unit is a signal indicating the overcurrent. Therefore, if the logical AND of these two results is logically high, it is determined that the switch has failed, and this makes it possible to improve the detection accuracy of a short-circuit failure of the switch.

In contrast, when there is inconsistency in these conditions, it is determined that at least any one of a short-circuit failure of the switch, a failure of the current sensor, and a failure of the gate driver has occurred.

In the power converter according to the ninth aspect of the present disclosure, in the eighth aspect, in a state where no voltage is being applied to the DC power supply unit, the failure detecting unit may detect a failure of the switch drive unit when an overcurrent notification signal is notified from the switch drive unit.

The state where no voltage is being applied to the DC power supply unit means a state where no current is flowing in the switch. In such a case, when the overcurrent notification signal that provides notification of the overcurrent is notified from the switch drive unit, it is determined that the switch drive unit itself has failed.

The program of the present disclosure is a program that causes a computer to function as the failure detecting unit according to any one of the first aspect to the ninth aspect.

The method of detecting a switch failure of the power converter of the present disclosure is a method of detecting a switch failure of a power converter including a smoothing capacitor connected to DC bus lines of a DC power supply unit, a resistor for suppressing rush current flowing into the smoothing capacitor, and a switch connected parallel to the resistor, and the method includes: measuring current flowing in the switch by a current sensor connected in series to the switch; at a computer, controlling opening and closing of the switch so as to open the switch at start of operation and then close the switch when a predetermined condition is met; and detecting a failure of the switch based on opening and closing control of the switch and a measured value of the current sensor.

### [Reference Signs List]

- 1: power converter
- 1a: power converter
- 2: DC power supply unit
- 2a: DC power supply unit
- 3: inverter
- 4: motor
- 5: control device
- 5a: control device
- 21: smoothing capacitor
- 22: resistor
- 23: switch
- 23a: switch
- 24: coil
- 25: main contactor
- 26: current sensor
- 28: gate driver
- 29: voltage dividing resistor
- 30: power supply
- Ith1: first current threshold
- Ith2: second current threshold
- Ith3: third current threshold

## Claims

1. A power converter comprising a smoothing capacitor connected to DC bus lines of a DC power supply unit, a resistor for suppressing rush current flowing into the smoothing capacitor, and a switch connected parallel to the resistor, the power converter comprising:
a current sensor connected in series to the switch and configured to measure current flowing in the switch;
a switch control unit configured to open the switch at start of operation and then close the switch when a predetermined condition is met; and
a failure detecting unit configured to detect a failure of the switch based on a measured value of the current sensor.

2. The power converter according to claim 1, wherein the switch is a semiconductor switch, the power converter further comprising
a switch drive unit configured to drive the semiconductor switch based on an instruction from the switch control unit.

3. The power converter according to claim 1, wherein the current sensor is an isolated current sensor.

4. The power converter according to claim 1, wherein in a state where no voltage is being applied to the DC power supply unit, the failure detecting unit detects a failure of the current sensor when the measured value of the current sensor is greater than a predetermined first threshold.

5. The power converter according to claim 1, wherein when a voltage is being applied to the DC power supply unit and the switch is controlled in an open state by the switch control unit, the failure detecting unit detects a short-circuit failure of the switch when the measured value of the current sensor is greater than a predetermined second threshold.

6. The power converter according to claim 1, wherein when a voltage is being applied to the DC power supply unit and the switch is controlled in a closed state by the switch control unit, the failure detecting unit detects an open-circuit failure of the switch when the measured value of the current sensor is less than or equal to a predetermined third threshold.

7. The power converter according to claim 2,
wherein the switch drive unit comprises an anomaly diagnosis unit, and
wherein the failure detecting unit detects an anomaly of the switch drive unit based on an anomaly notification signal output from the switch drive unit.

8. The power converter according to claim 2,
wherein the switch drive unit comprises an overcurrent detecting unit configured to detect whether or not overcurrent is flowing in the switch, and
wherein the failure detecting unit detects a failure of the switch by evaluating consistency between an overcurrent notification signal output from the switch drive unit and failure detection based on the measured value of the current sensor.

9. The power converter according to claim 8, wherein in a state where no voltage is being applied to the DC power supply unit, the failure detecting unit detects a failure of the switch drive unit when an overcurrent notification signal is notified from the switch drive unit.

10. A program that causes a computer to function as the failure detecting unit according to claim 1.

11. A method of detecting a switch failure of a power converter comprising a smoothing capacitor connected to DC bus lines of a DC power supply unit, a resistor for suppressing rush current flowing into the smoothing capacitor, and a switch connected parallel to the resistor, the method comprising:
measuring current flowing in the switch by a current sensor connected in series to the switch;
at a computer,
controlling opening and closing of the switch so as to open the switch at start of operation and then close the switch when a predetermined condition is met; and
detecting a failure of the switch based on opening and closing control of the switch and a measured value of the current sensor.
